(19) **Europäisches Patentamt / European Patent Office / Office européen des brevets**

(11) **EP 4 327 460 B1**

(12) **EUROPEAN PATENT SPECIFICATION**

(45) Date of publication and mention
of the grant of the patent:
**25.03.2026 Bulletin 2026/13**

(21) Application number: **21743380.4**

(22) Date of filing: **30.06.2021**

(51) International Patent Classification (IPC):
**H03M 13/29** $^{(2006.01)}$   **H03M 13/11** $^{(2006.01)}$
**H03M 13/00** $^{(2006.01)}$   **H03M 13/35** $^{(2006.01)}$

(52) Cooperative Patent Classification (CPC):
**H03M 13/1128; H03M 13/2975; H03M 13/353;
H03M 13/6306**

(86) International application number:
**PCT/EP2021/068065**

(87) International publication number:
**WO 2023/274528 (05.01.2023 Gazette 2023/01)**

## (54) VIRTUALIZED RADIO ACCESS POINT, VRAP, AND METHOD OF OPERATING THE SAME

VIRTUALISIERTER FUNKZUGANGSPUNKT, VRAP UND VERFAHREN ZUM BETRIEB DAVON

POINT D'ACCÈS RADIO VIRTUALISÉ (VRAP) ET SON PROCÉDÉ DE FONCTIONNEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.02.2024 Bulletin 2024/09**

(73) Proprietor: **NEC Corporation
Minato-ku
Tokyo 108-8001 (JP)**

(72) Inventors:
• **GARCIA SAAVEDRA, Andres**
  **69115 Heidelberg (DE)**
• **COSTA-PÉREZ, Xavier**
  **69115 Heidelberg (DE)**

(74) Representative: **Ullrich & Naumann PartG mbB
Schneidmühlstrasse 21
69115 Heidelberg (DE)**

(56) References cited:
**WO-A1-2018/095796     US-A1- 2013 223 485**

• **INTEL: "vRAN: The Next Step in Network
Transformation", WHITE PAPER, 1 January 2019
(2019-01-01), pages 1 - 10, XP055893517,
Retrieved from the Internet <URL:https://www.
windriver.com/whitepapers/networking/
vran-the-next-step-in-network-transformation>
[retrieved on 20220218]**
• **SAMSUNG: "Virtualized Radio Access Network,
Architecture, Key technologies and Benefitss",
TECHNICAL REPORT, 1 January 2019
(2019-01-01), XP055893505, Retrieved from the
Internet <URL:https://images.samsung.com/is/
content/samsung/assets/global/business/
networks/insights/white-papers/
virtualized-radio-access-network/
white-paper_virtualized-radio-access-net
work_1.pdf> [retrieved on 20220218]**
• **CHUNLONG BAI ET AL: "Hardware
implementation of Log-MAP turbo decoder for
W-CDMA Node B with CRC-aided early
stopping", PROC., IEEE 55TH. VEHICULAR
TECHNOLOGY CONFERENCE, VTC SPRING
2002, BIRMINGHAM, AL, vol. 2, 6 May 2002
(2002-05-06) - 9 May 2002 (2002-05-09), pages
1016 - 1019, XP002289205, ISBN:
978-0-7803-7484-3, DOI: 10.1109/
VTC.2002.1002642**

EP 4 327 460 B1

- **KIENLE F ET AL: "Low Complexity Stopping Criterion for LDPC Code Decoders", PROC., IEEE 61ST VEHICULAR TECHNOLOGY CONFERENCE. VTC2005- SPRING ; 30 MAY-1 JUNE 2005 ; STOCKHOLM, SWEDEN, IEEE, PISCATAWAY, NJ, USA, vol. 1, 30 May 2005 (2005-05-30), pages 606 - 609, XP010855466, ISBN: 978-0-7803-8887-1, DOI: 10.1109/ VETECS.2005.1543363**
- **P SALIJA ET AL: "An Efficient Early Iteration Termination for Turbo Decoder", JOURNAL OF TELECOMMUNICATIONS AND INFORMATION TECHNOLOGY, 1 April 2016 (2016-04-01), Warsaw, pages 113 - 122, XP055893522, Retrieved from the Internet <URL:http://yadda. icm.edu.pl/baztech/element/bwmeta1.element. baz tech-80b03ccc-946c-4cf8-9952-7c27bf86b961> [retrieved on 20220218]**
- **JIANGPENG LI ET AL: "Memory efficient layered decoder design with early termination for LDPC codes", PROC., IEEE INTERNATIONAL SYMPOSIUM ON CIRCUITS AND SYSTEMS, ISCAS 2011, 15 May 2011 (2011-05-15), pages 2697 - 2700, XP031998214, ISBN: 978-1-4244-9473-6, DOI: 10.1109/ ISCAS.2011.5938161**

**Description**

The present invention relates to a virtualized radio access point, vRAP, and to a method of operating the same.

The virtualization of radio access networks (RANs), based hitherto on monolithic appliances over application-specific integrated circuits (ASICs), will become the spearhead of next-generation mobile systems beyond 5G and 6G. Initiatives such as the carrier-led O-RAN alliance or Rakuten's greenfield deployment in Japan have spurred the market - and so the research community - to find novel solutions that import the flexibility and cost-efficiency of network function virtualization (NFV) into the very far edge of mobile networks.

Compared to purpose-built RAN hardware, virtualized RANs (vRANs) pose several advantages, such as:

1. Leverage off-the-shelf platforms, which are more cost-efficient over the long-term due to economies of scale;
2. Harmonize the ecosystem, which helps reduce costs;
3. Leverage tools such as agile, DevOps or CI/CD, which shorten development cycles; and
4. Enable seamless integration of cloud technologies, which lowers barriers for competition and innovation.

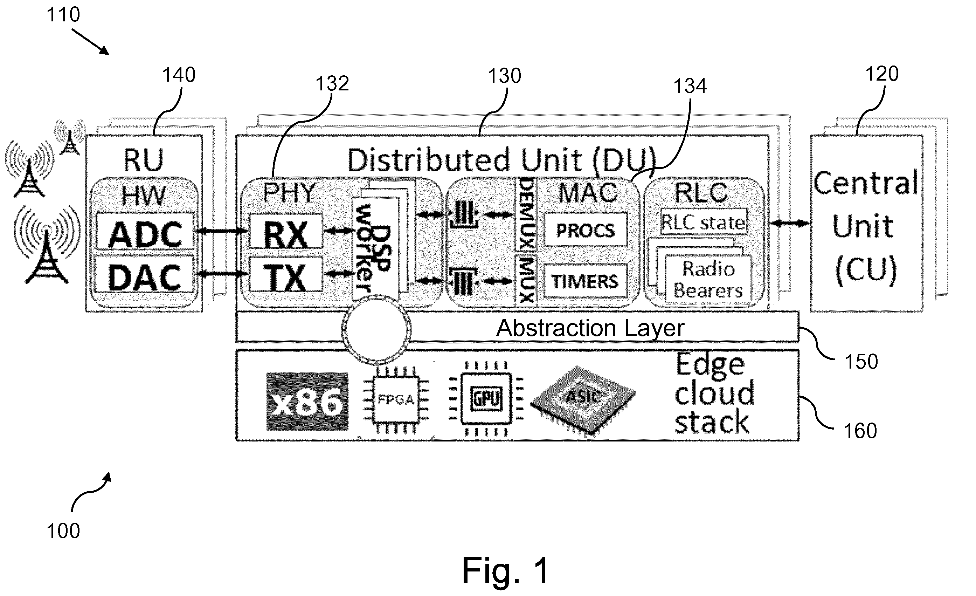

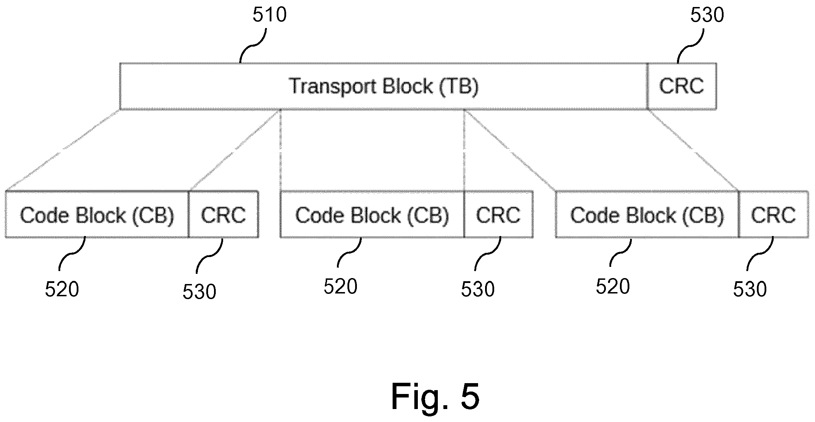

Fig. 1 shows the architecture of a vRAN 100 according to prior art. More specifically, Fig. 1 schematically illustrates the structure of a base station (BS), i.e. radio access point (RAP) 110 in a 5G RAN architecture. Regardless of the different terminology used for the radio access point - eNodeB (eNB) in 4G LTE or gNodeB (gNB) in 5G - the term RAP, or vRAP for its virtualized counterpart, will be used in the present disclosure as an abstraction. As depicted in Fig. 1, 5G splits each RAP 110 into a central unit (CU) 120, hosting the highest layer of the stack; a distributed unit (DU) 130, hosting the physical layer (PHY) 132 and the MAC (Media Access Control) scheduler 134; and a radio unit (RU) 140, hosting basic radio functions such as amplification or sampling.

As can be obtained from Fig. 1, vRANs 100 shall rely on cloud platforms, comprised of pools of shared computing resources 150 (mostly CPUs, but also GPUs, FPGAs and other hardware accelerators brokered by an abstraction layer 160, for reference, see, e.g. bbdev (https://doc.dpdk.org/guides/prog_guide/bbdev.html)), to host virtualized functions such as the PHY.

However, while CUs are amenable to virtualization in regional clouds, virtualized DUs (vDUs) - specifically the vPHY therein - require fast and predictable computation in edge clouds. Clouds provide a harsh environment for DUs because they trade off the predictability supplied by dedicated platforms for higher flexibility and cost-efficiency. Indeed, research has shown that resource contention in cloud infrastructure, even when placing virtual functions on separate cores, may lead to up to 40% of performance degradation compared to dedicated platforms - the so-called *noisy neighbor* problem.

This is certainly an issue for traditional network functions such as virtual switches, firewalls, VPNs, or even CUs, which *only* suffer a performance degradation that is proportional to the computing fluctuations caused by resource contention. For contemporary 4G/5G PHY pipelines, however, such fluctuations are simply catastrophic. Consequently, a main challenge for DU virtualization is to design a virtual PHY processor that preserves carrier-grade performance in cloud platforms at the edge.

Recently, E-HARQ (Early Hybrid Automated Repeat Request) is receiving attention in the context of low-latency communications. The approach is usually to design appropriate stopping criteria for the iterative algorithms employed by turbo decoders (as disclosed, e.g., in P. Salija and B.Yamuna: "An efficient early iteration termination for turbo decoder ", in Journal of Telecommunications and Information Technology, 2016) or LDPC decoders (as disclosed, e.g., in Jiangpeng Li et al.: "Memory efficient layered decoder design with early termination for LDPC codes", in 2011 IEEE International Symposium of Circuits and Systems (ISCAS), IEEE, 2697-2700), or to predict the decodability of the data to send HARQ feedback early (as disclosed, e.g., in Nils Strodthoff et al.: "Enhanced machine learning techniques for early HARQ feedback prediction", in 5G.IEEE Journal on Selected Areas in Communications 37, 11 (2019), 2573-2587).

However, these approaches merely aim at reducing delay and have therefore a limited efficiency only.

Further relevant prior art documents are:

- US 2013/223485 A1
- Intel: "vRAN: The Next Step in Network Transformation", White Paper, 1 January 2019, pages 1-10,
- Samsung: "Virtualized Radio Access Network, Architecture, Key technologies and Benefits", Technical Report, 1 January 2019
- CHUNLONG BAI ET AL: "Hardware implementation of Log-MAP turbo decoder for W-CDMA Node B with CRC-aided early stopping", PROC., IEEE 55TH. VEHICULAR TECHNOLOGY CONFERENCE, VTC SPRING 2002, BIRMINGHAM, AL, vol. 2, 6 May 2002 - 9 May 2002, pages 1016-1019, DOI: 10.1109/VTC.2002.1002642 ISBN: 978-0-7803-7484-3
- WO 2018/095796 A1
- KIENLE F ET AL: "Low Complexity Stopping Criterion for LDPC Code Decoders", PROC., IEEE 61ST VEHICULAR TECHNOLOGY CONFERENCE. VTC2005- SPRING ; 30 MAY-1 JUNE 2005 ; STOCKHOLM, SWEDEN, IEEE, PISCATAWAY, NJ, USA, vol. 1, 30 May 2005, pages 606-609, DOI: 10.1109/VETECS.2005.1543363 ISBN: 978-0-7803-8887-1
- P Salija ET AL: "An Efficient Early Iteration Termination for Turbo Decoder", Journal of Telecommunications and Information Technology, 1 April 2016 (2016-04-01), pages 113-122, Warsaw

It is an object of the present invention to improve and further develop a virtualized radio access point, vRAP, and a method of operating the same in such a way that high-performing DU virtualization is enabled in order to maximize performance in cloud-based virtualized RANs.

In accordance with the invention, the aforementioned object is accomplished by a method of operating a virtualized radio access point, vRAP, as defined by claim 1.

Furthermore, the aforementioned object is accomplished by a virtualized radio access point, vRAP, as defined by claim 8.

According to the invention it has first been recognized that common cloud platforms, typically comprised of pools of shared computing resources (mostly CPUs, but also hardware accelerators brokered by an abstraction layer), provide a harsh environment for 4G/5G (and possibly beyond) virtualized distributed units (vDUs) because they trade off the predictability supplied by dedicated platforms for higher flexibility and cost-efficiency. Therefore, embodiments of the present invention aim at improving the efficiency of virtualized PHYs when data processing tasks cannot be finished in time due to e.g., cloud computing fluctuations. As a solution, embodiments of the present invention built upon two main techniques: (i) Hybrid Automated Repeat Request (HARQ) prediction, and (ii) congestion control, aims at increasing the performance of vDUs running on cloud platforms. Specifically, embodiments of the invention propose a HARQ prediction mechanism that 1) avoids forcing users to retransmit data that would be decodable if they had more computing budget time and 2) provides information to the MAC scheduler of the vRAP to control the rate of data to the availability of computing resources in the edge cloud. As a result, the efficiency of virtualized base stations (O-RAN) is increased.

It should be noted that, while the above mentioned E-HARQ related approaches just try to reduce delay, embodiment of the present invention differ from these approaches in that extrinsic information from the decoders is exploited to infer the decodability of data to provide extra computing time budget to data processing workers and possibly adapt the rate of data to the computing capacity of the system.

According to an embodiment of the present invention, the codes used for decoding transport blocks, TBs (or the code blocks, CBs, of a TB, respectively) may include turbo codes and/or LDPC (low-density parity-check) codes. Both types of decoder may employ an iterative belief propagation algorithms, which may be exploited to infer the future decodability of each TB (or CB, respectively).

According to an embodiment, the decoder may be a turbo decoder configured to operate based on two interleaved convolutional codes. More specifically, the turbo decoder may be configured to execute a belief propagation algorithm that is implemented by two convolutional decoders that exchange extrinsic log-likelihood ratios, LLRs, iteratively. In this regard, it may be provided that the LLRs represent a reliability information computed for a received sequence of systematic bits and parity bits generated by the corresponding turbo encoder.

According to the invention, inferring information about the decodability of the data of the TBs includes determining, based on an analysis of the exchanged extrinsic information, a decodability status of the data as either 'decodable', 'undecodable' or 'unknown'.

According to an embodiment, processing extrinsic information for inferring information about the decodability of the data of the TBs may be performed when a deadline for computing signals to send feedback to the respective users expires.

According to an embodiment, it may be provided that the magnitude of the extrinsic information after the last decoding iteration is determined. Based thereupon, it can be inferred that the respective data are decodable if the determined magnitude exceeds a first configurable threshold. Alternatively or additionally, it may be provided that the trend of the magnitude of the extrinsic information over the decoding iterations is determined. Based thereupon, it can be inferred that the respective data are decodable if the determined trend exceeds a second configurable threshold. These tasks can be performed by appropriately built classifiers.

According to an embodiment, it may be provided that, if user data are determined to be decodable, a signal is computed to acknowledge its successful reception to the transmitter (e.g. by sending an ACK to the respective user), while the decoder may continue processing the user data in parallel.

According to an embodiment, it may be provided that, if user data are determined to be undecodable or if the inferred information about the decodability do not permit to determine whether user data are decodable or not, decoding the data is stopped and the signals to request the user to retransmit the data are computed.

According to an embodiment, it may be provided that, if user data are determined to be decodable, the amount of data the MAC scheduler is allowed to allocate to users is increased. Alternatively or additionally, it may be provided that, if user data are determined to be undecodable or if the inferred information about the decodability do not permit to determine whether user data are decodable or not, the amount of data the MAC scheduler is allowed to allocate to users is decreased.

According to the invention, the inferred information about the decodability of data is used to adapt the rate at which uplink data is scheduled to the availability of the vRAP's computing capacity. For instance, this may be accomplished by using additive-increase/multiplicative-decrease (AIMD) algorithms.

According to embodiments, the DSP pipeline of the vRAP may be configured to process 4G LTE or 5G NR workloads in sub 6 GHz frequency bands that are virtualized in general-purpose CPU clouds.

There are several ways how to design and further develop the teaching of the present invention in an advantageous way. To this end, it is to be referred to the dependent claims on the one hand and to the following explanation of preferred embodiments of the invention by way of example, illustrated by the figure on the other hand. In connection with the explanation of the preferred embodiments of the invention by the aid of the figure, generally preferred embodiments and further developments of the teaching will be explained. In the drawing

Fig. 1      is a schematic view illustrating the concept of virtualized RAN architecture according to prior art,

Fig. 2      is a schematic view illustrating pipeline parallelization in a conventional baseline digital signal processor (DSP) according to prior art,

Fig. 3      is a diagram showing the decoding time of one transport block in a CPU core,

Fig. 4      is a schematic view illustrating the basic concept of a multi-thread PHY pipeline according to a previous solution,

Fig. 5      is a schematic view illustrating the structure of a transport block (TB) as implemented in 4G/5G.

Fig. 6      is a schematic view illustrating an exemplary architecture of a turbo encoder (a) and a turbo decoder (b),

Fig. 7      is a diagram exemplarily illustrating experimental results of the mean extrinsic magnitude for each iteration of a turbo decoder,

Fig. 8      is a diagram schematically illustrating the concept of a HARQ prediction approach in accordance with an embodiment of the present invention,

Fig. 9      is a diagram schematically illustrating the scenario with a decodable transport block in accordance with an embodiment of the present invention,

Fig. 10      is a diagram schematically illustrating the scenario with an undecodable transport block in accordance with an embodiment of the present invention, and

Fig. 11      is a diagram schematically illustrating the scenario with an inconclusive decodability of a transport block in accordance with an embodiment of the present invention.

4G LTE and 5G NR (NR) PHYs have a number of similarities. Therefore, before describing embodiments of the invention in detail, first, the most important aspects of 4G LTE and 5G New Radio that are relevant for at least some embodiments of the invention and that will probably ease their understanding, are introduced and the key insufficiencies of a legacy pipeline will be outlined. A more detailed description of the respective technology can be obtained from Erik Dahlman, Stefan Parkvall, and Johan Skold. 2018.5G NR: "The next generation wireless access technology", Academic Press and references therein.

5G NR adopts orthogonal frequency division multiplexing access (OFDMA) with cyclic prefix (CP) for both downlink (DL) and uplink (UL) transmissions, which enables fine-grained scheduling and multiple-input multiple-output (MIMO) techniques. While LTE also adopts OFDM in the DL, it relies on single-carrier FDMA (SC-FDMA) for the UL, a linearly precoded flavor of OFDMA that reduces peak-to-average power ratio in mobile terminals. The numerology differs between LTE and NR. In both cases, a subframe (SF) consists of a transmission time interval (TTI) that lasts 1 ms, and a frame aggregates 10 SFs. LTE has a fixed numerology with inter-subcarrier spacing equal to 15 kHz, and a SF being composed of 2 slots, each with 7 (with normal CP) or 6 (with extended CP) OFDM symbols. In contrast, NR allows different numerologies, with tunable subcarrier spacing between 15 and 240 KHz. To support this, NR divides each SF into one or more slots, each with 14 (with normal CP) or 12 (with extended CP) OFDM symbols. Finally, LTE supports different bandwidth configurations, up to 20 MHz, whereas NR allows up to 100 MHz in sub-6GHz spectrum; and both support carrier aggregation with up to 5 (LTE) or 16 (NR) carriers.

The PHY is organized into *channels,* which are multiplexed in time and frequency. Although LTE and NR use mildly different channel formats and time/spectrum allocations, they are conceptually very similar. The unit of transmission is the transport block (TB). Within each TTI, PDSCH (Physical DL Shared Channel) and/or PUSCH (Physical UL Shared Channel ) carries one TB per user (or two, in case of spatial multiplexing with more than four layers in DL) as indicated by PDCCH's (Physical DL Control Channel) Downlink Control Information (DCI), which carries DL and UL resource scheduling information. The size of the TB is variable and depends on the modulation and coding scheme (MCS) used for transmission, which in turn depends on the signal quality, and of course on the state of data buffers. Hybrid automatic repeat request (HARQ), combining forward error correction and ARQ, is used for error control. To this end, explicit feedback is received from the users in UL Control Information (UCI) messages carried by PUSCH or PUCCH (Physical UL Control Channel), and TBs are encoded with low-density parity-check codes (NR) or turbo codes (LTE).

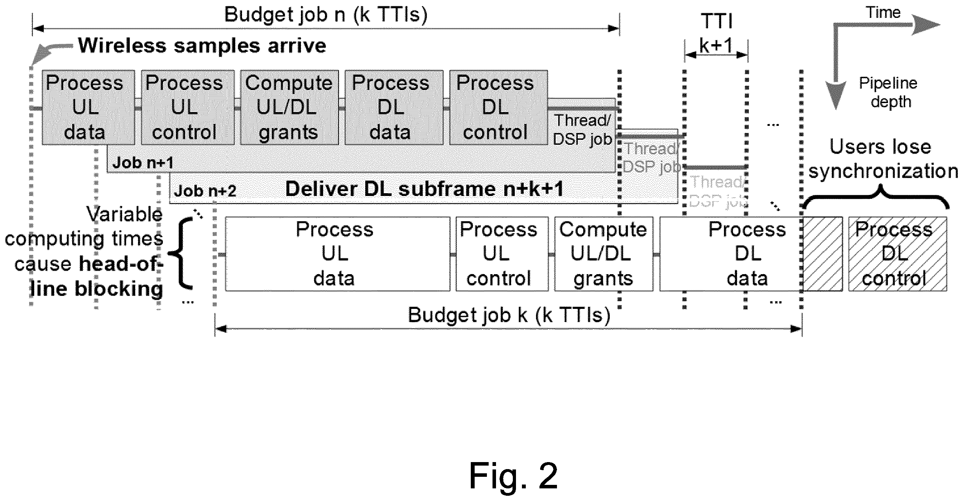

Fig. 2 illustrates the operation of a digital signal processor (DSP) that is commonly used to implement a 4G/5G PHY. Every transmission time interval (TTI), which is usually 1 ms in 4G/5G, a DSP worker initiates a job comprised of a pipeline of tasks, including: (i) processing an uplink (UL) subframe, (ii) scheduling UL and downlink (DL) grants, and (iii) compiling a DL subframe.

As already mentioned before, cellular systems implement a Hybrid Automated Repeat Request (HARQ) mechanism, which mixes forward error correction (FEC) coding with explicit ARQ feedback encoded into ACK (acknowledgement) or NACK (not acknowledgement) signals such that the user can retransmit undecodable data (due to bad channel conditions, for instance) or transmit new data instead.

The above pipeline of tasks has to be processed sequentially because of the dependency among them: In order to compile a DL subframe, UL and DL grants have to be computed because the signaling required to inform the users of UL and DL scheduling decisions is carried by the DL subframe. Moreover, in order to compute DL and UL grants, UL data processing tasks must be completed because UL grants depend on the decodability of UL data. For instance, if UL data cannot be decoded due to bad channel conditions, appropriate grants to schedule retransmissions and a non-acknowledgement signal (NACK) have to be computed. Conversely, if UL data has been successfully decoded, an acknowledgement (ACK) has to be mapped into the DL subframe.

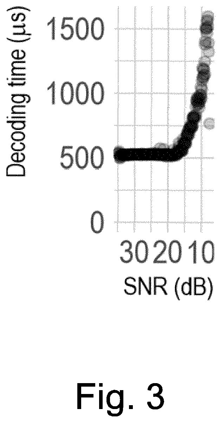

In addition, these are compute-intensive tasks and hence processing a job within 1 ms is challenging. For instance, Fig. 3 depicts the time it takes for a general-purpose CPU to decode a transport block of data from one user - just one out of many operations when processing an UL subframe - encoded with a mild modulation and coding scheme in a 20-MHz channel, and enduring different signal-to-noise-ratio (SNR) settings. However, processing a DSP job every TTI (e.g. every 1 ms) is vital to preserve synchronization and process control information. To give workers some slack, pipeline parallelization is commonly used, that is, a pool of workers processes multiple jobs in parallel as shown in Fig. 2. In this way, with a pool of k workers, each job n gets a computing budget of roughly k TTIs to process UL subframe n (corresponding to the nth TTI) and compile DL subframe n+k+1 (carrying DL signals during the (n+k+1)th TTI). Albeit this approach is the basis for most of the work conducted to date, it is certainly not sufficient for carrier-grade cloud-based vDUs.

One important problem is the fact that processing UL data is time-consuming (see Fig. 3) and hence causes head-of-line blocking, as illustrated at the bottom of Fig. 2, which compromises the delivery of DL grants in addition to causing synchronization and control plane issues. Moreover, the amount of computing time required by this task is also context-dependent, that is, it varies depending on the channel quality (and hence on the mobility of the users and other channel dynamics), the network load dynamics, and on cloud computing fluctuations due to resource contention when multiple vDU instances share the platform.

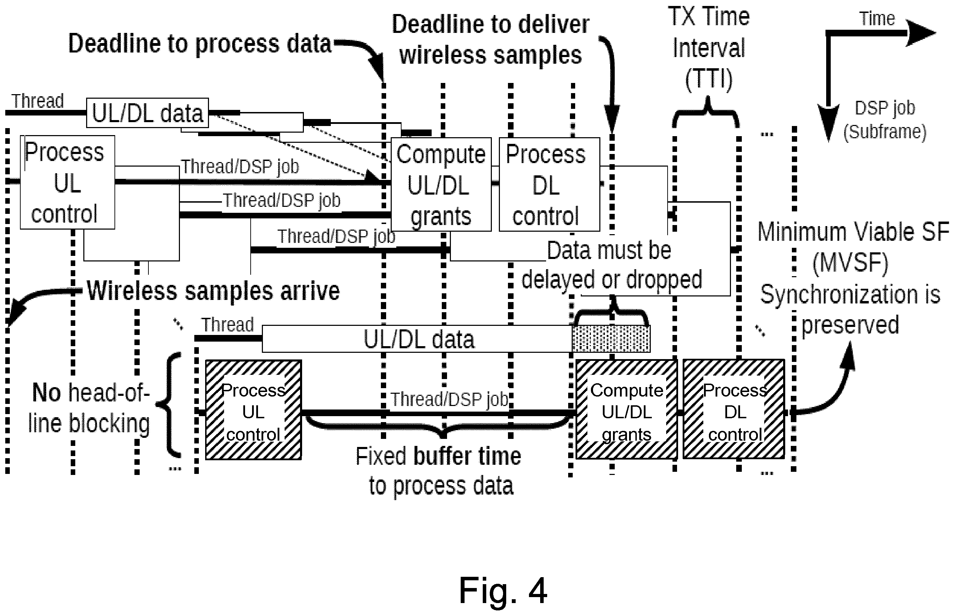

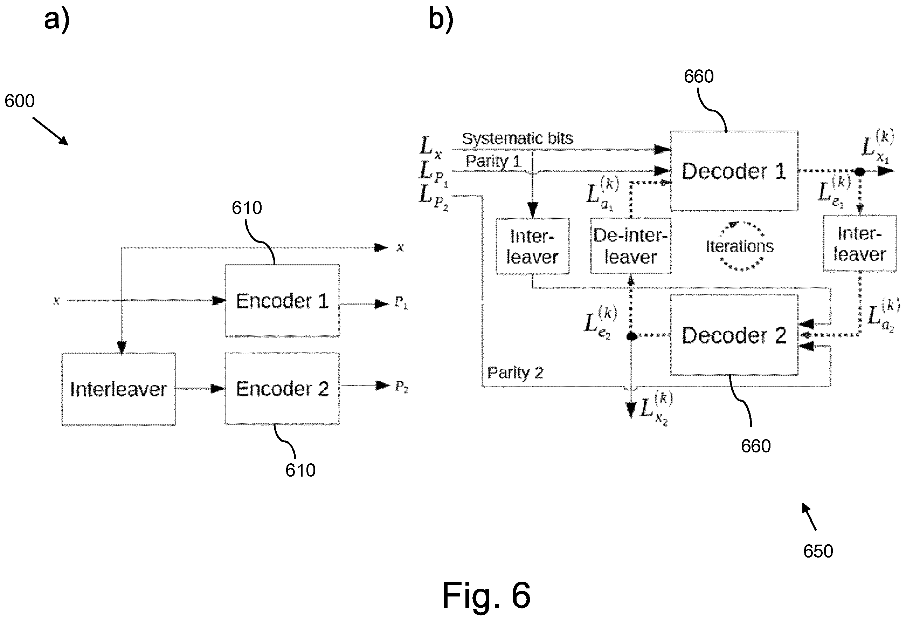

One solution to the aforementioned head-of-line blocking problem is to allocate a fixed time budget to uplink data processing tasks (PUSCH processing) in order to make sure that head-of-line blocking does not incur into violating the whole job's budget. An example of an approach that implements this solution is described in the applicant's previous application PCT/EP2020/083054 (not yet published), which decouples data processing tasks such as UL data processing tasks in parallel threads with a fixed time budget. If, upon exhausting this budget, the task is unfinished, it is discarded and the user is requested to retransmit its data. This is illustrated in the bottom part of Fig. 4 (which corresponds to Fig. 6 of the above mentioned previous application).

However, when the timer on data processing tasks expire (such as in case of the job depicted with a hatched area at the bottom of Fig. 4), data has to be discarded because it has not been yet decoded satisfactorily, feedback must be sent to the users and UL/DL grants have to be computed accordingly. Embodiments of the present invention aim at improving the efficiency of virtualized PHYs when data processing tasks cannot be finished in time due to e.g., cloud computing fluctuations (such as in case of the job depicted with a hatched at the bottom of Fig. 4). Specifically, embodiments of the invention provide a solution that proposes a HARQ prediction mechanism that 1) avoids forcing users to retransmit data that would be decodable if they had more computing budget time and/or 2) provides information to the MAC scheduler to control the rate of data to the availability of computing resources in the edge cloud.

Each DSP job carries a number of transport blocks (TBs) 510, usually one per user, which carry user data. To encode/decode TBs in 4G/5G, each TB (usually 1 ms) is divided into multiple equal size *code blocks* (CBs) 520 of up to 8448 bits. Both the TB and each code block have a 16-bit or 32-bit cyclic redundancy check (CRC) 530 attached for error detection, as shown in Fig. 5.

4G/5G encode/decode CBs using turbo codes or LDPC codes, which are capable of achieving close-to-Shannon capacity and are amenable to efficient implementation. On the one hand, a turbo decoder consists of two interleaved concatenated convolutional codes, which exchange extrinsic information, and a trellis soft-decision algorithm that run iteratively. On the other hand, LDPC codes are linear block codes with sparse parity check matrices represented by a bipartite graph, which are decoded with a soft message passing algorithm. They have fundamental similarities, among which the most relevant is that both approaches employ an iterative belief propagation algorithm. Embodiments of the present invention exploit this iterative belief propagation algorithm to infer the future decodability of each TB. However, before describing embodiments of the present invention in more detail, in the following a brief overview of turbocoding is provided to introduce the concept of *extrinsic* information that is leveraged for decodability prediction according to embodiments of the invention.

As an example, Fig. 6 illustrates the architecture of a turbo encoder (Fig. 6a) and a turbo decoder (Fig. 6b). A turbo encoder 600 consists of two convolutional encoders 610 (Encoder 1 and Encoder 2). CBs are encoded/decoded one by one. For every CB, its constituent bits $\vec{x}$ are fed into the turbo encoder 600. The output consists of a sequence of systematic bits x and a sequence of parity bits. The output of Encoder 1 generates a sequence of parity bits $\overrightarrow{P_1}$, and Encoder 2 generates a second sequence of parity bits $\overrightarrow{P_2}$, using an interleaved version of $\vec{x}$, i.e., $\bar{x}$.

The receiver receives a possibly distorted version of the systematic bits and parity bits. A soft-output detector computes the reliability information as log-likelihood ratios (LLR) for the received sequence of systematic bits $\overrightarrow{L_x}$ and parity bits $\overrightarrow{L_{Pi}}$ for $i = \{1,2\}$. The sign of an LLR indicates the bit that is inferred, and its magnitude indicates the certainty of such inference. The turbo decoder's 650 belief propagation algorithm is implemented by two decoders (Decoder 1 and Decoder 2) 660 that exchange *extrinsic* LLRs $\overrightarrow{L_{ei}}^{(k)}$ iteratively, where $k = \{1,2, ...\}$ indexes each full iteration. To this end, every iteration $k$, decoder $i$ uses a maximum a-posteriori (MAP) algorithm to compute *a-posteriori* LLRs $\overrightarrow{L_{xi}}^{(k)}$ based on the systematic LLRs $\overrightarrow{L_x}$ (in case of $i = 1$) or $\overrightarrow{L_{\bar{x}}}$ (i.e., interleaved, in case of $i = 2$), on the respective parity LLRs $\overrightarrow{L_{Pi}}$ and on the so-called *a-priori* LLRs $\overrightarrow{L_{ai}}^{(k)}$. Initially, $\overrightarrow{L_{a1}}^{(1)} = 0$. In subsequent half-iterations, each decoder 660 computes *extrinsic* LLRs as

$$\overrightarrow{L_{e_l}}^{(k)} = \overrightarrow{L_{x_l}}^{(k)} - \overrightarrow{L_x} - \overrightarrow{L_{a_m}}^{(k)}, \ \forall i \neq m \in \{1,2\}$$

That is, as depicted in Fig. 6b, $\overrightarrow{L_{a1}}^{(k)}$ is a deinterleaved version of $\overrightarrow{L_{e1}}^{(k)}$, and $\overrightarrow{L_{a2}}^{(k)}$ is an interleaved version of $\overrightarrow{L_{e2}}^{(k)}$. At each full iteration $k$, CRC validation is used as a stopping criterion.

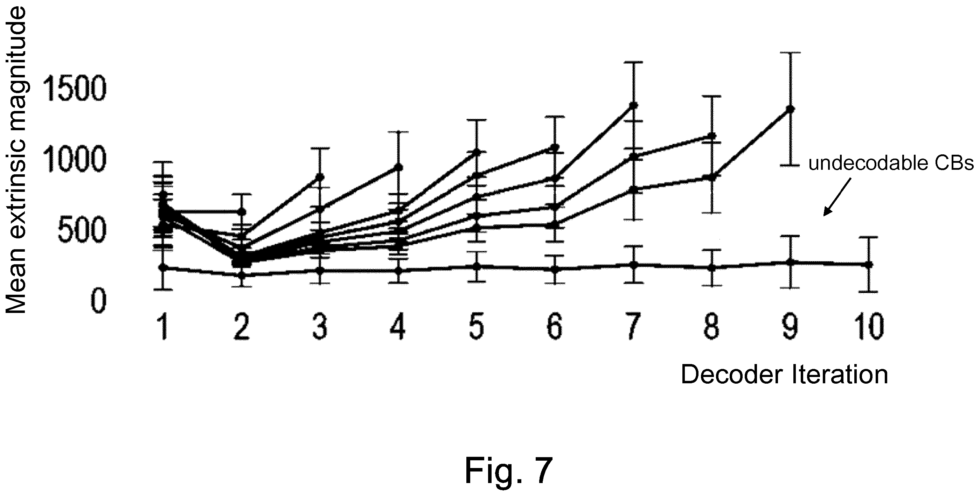

Fig. 7 illustrates the evolution of the magnitude of the average extrinsic value in CBs of different nature. Specifically, the dots/lines represent the average value across multiple CBs with different MCS (Modulation and Coding Scheme), TBS (Transport Block Size) and SNR (Signal-to-Noise Ratio). Error bars indicate the standard deviation According to the illustrated example, a CB is decodable if the decoder requires less than 10 iterations to extract data from the CB. Conversely, undecodable CBs reach the 10th iteration (as shown in the bottom line in Fig. 7). This experimental result validates the approach according to embodiments of the invention disclosed herein: Decodable CBs do present patterns in mean extrinsic magnitude that are distinguishable from those for undecodable CBs, which can be used to infer the decodability of CBs.

According to an embodiment, the present invention provides a method of operating a virtualized radio access point, vRAP, that exploits extrinsic information, which propagates along every iteration in LDPC and turbo decoders, among others, to predict the decodability of CBs, when the time budget to process uplink processing tasks (PUSCH) expires. This enables to provide both reliability (as PUSCH decoding tasks have a hard time deadline and therefore do not cause head-of-line blocking as introduced earlier), yet preserve spectrum efficiency (as it becomes possible to opportunistically acknowledge data to the users while the decoder continues to process the data, instead of discarding this data and requesting the users to retransmit).

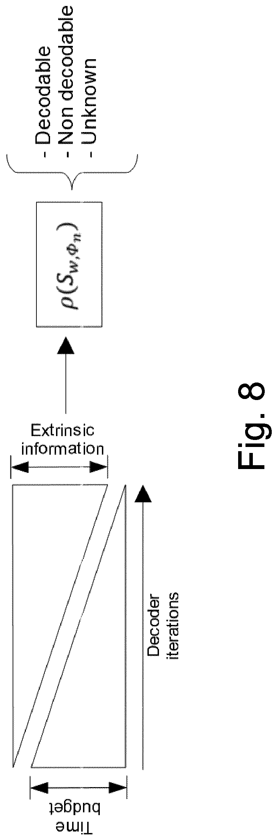

Specifically, according to an embodiment of the invention it may be provided to extrinsic information spawning from the decoding operation at each iteration. When the time budget of DSP job $n$ expires at time $\Phi_n$, it may be provided to observe the state $S$ of the decoding task being executed by each unfinished worker w processing transport blocks that have not matched CRC yet, $S_{w,t_n=\Phi_n}$ at that time within the job $t_n = \Phi_n$. In this embodiment, a state may be defined as a triple $S_w := \{K, \overrightarrow{L_{e1}}, \overrightarrow{L_{e2}}\}$, wherein $K \in \mathbb{N}$ denotes the number of full iterations completed so far by the decoder. $\overrightarrow{L_{e_l}} := \left[\frac{1}{N}\sum_{b=1}^{N}\left|L_{e_i,b}^{(1)}\right|, ..., \frac{1}{N}\sum_{b=1}^{N}\left|L_{e_i,b}^{(K)}\right|\right]$ for $i = \{1,2\}$ is a $k$-dimensional vector comprised of the mean magnitude of the extrinsic LLRs at each iteration $k = \{1, ... , K\}$, where $N$ is the length of the coded block being decoded and $L_{e_i,b}$ is the extrinsic LLR of bit b. Given $S_{w,\Phi_n}$ at time $\Phi_n$ (when the time budget expires), a rule $p(S_{w,\Phi_n}) \varepsilon \{DECODABLE, UNDECODABLE, UNKNOWN\}$ may be applied to decide upon the decodability, undecodability, or uncertain decodability of the TB. This approach is schematically illustrated in Fig. 8. Early stopping criteria, commonly used in 4G and 5G by using CRC can also be used complementarily to this and others embodiments described herein. That is, if the data is successfully decoded (i.e. CRC matches) before exhausting the time budget, the transport block may be acknowledged independently of the extrinsic information.

Embodiments of the present invention primarily aim at reaching either a decodable or an undecodable decision. The former evidently is desirable because in that case it is possible that the data is sent upstream in the protocol stack and that its successful reception is acknowledged to the transmitter. The latter is also desirable because it indicates the chunk of data cannot be decoded due to poor channel conditions and the MAC scheduler has already mechanisms to adapt to this scenario.

The third possible output as mentioned above, i.e. 'unknown', is however an indicator of deficit of computing resources, irrespective of the quality of the channel. According to an embodiment of the present invention, this information can be used by the MAC scheduler to adjust the amount of data that the users are allowed to send in order to adapt to the availability of computing capacity.

According to an embodiment of the present invention, this can be achieved by employing, for instance, an additive-increase/multiplicative-decrease (AIMD) algorithm to the amount of uplink resources allocated to the users. Specifically, a congestion window (*cwnd*) may be configured to constrain the maximum amount of physical resource blocks (PRBs) allocated to all users. Then, the MAC scheduler may increase the congestion window by M PRBs every code block that is declared decodable or undecodable in DSP job n. Conversely, the congestion window may multiplicatively decrease by a backoff factor U for every code block with unknown decodability, that is, $cwnd^{(n+1)} = (cwnd^{(n)} + \Sigma_m M)U^u$, where $m$ is the number code blocks declared decodable or undecodable and $u$ is the number of code blocks with unknown decodability.

According to further embodiments of the invention, the rule $\rho(S_{w,\Phi_n})$ may be defined based upon the following observations from Fig. 7, wherein standard classifiers can be used to implement the respective steps:

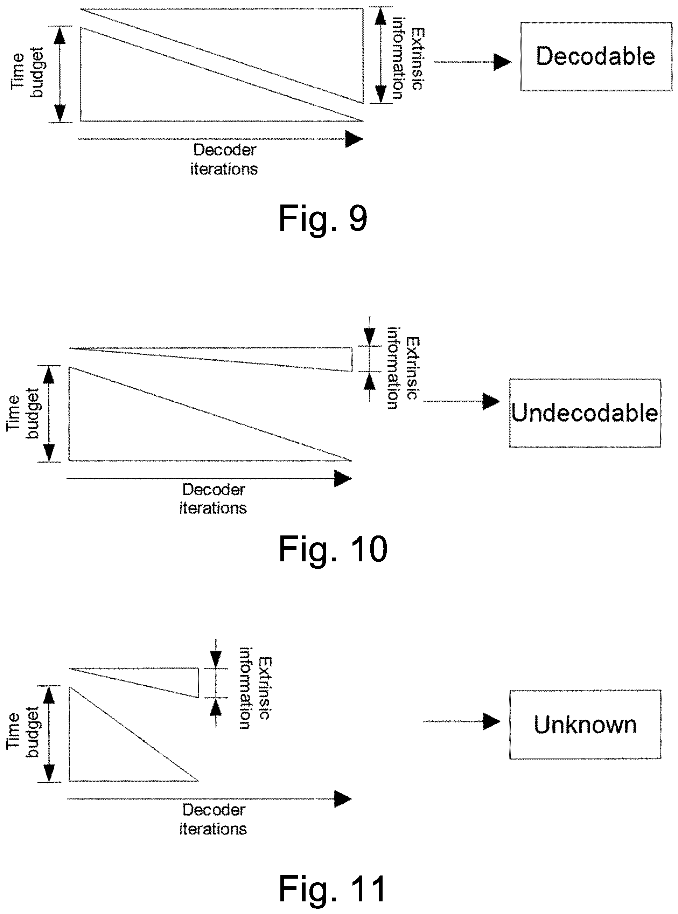

1. If the magnitude of the extrinsic information after the last decoder iteration is sufficiently large (e.g., exceeding a first predefined threshold) or if the trend of the magnitude of extrinsic information over iterations is sufficiently large (e.g., exceeding a second predefined threshold), it may be inferred that the code block is decodable. This scenario is schematically illustrated in Fig. 9.

2. Otherwise, if the total number of iterations is sufficiently high (e.g., exceeding a third predefined threshold), it may be inferred that the code block is not decodable and the user may be requested for retransmission. This scenario is schematically illustrated in Fig. 10.

3. Otherwise, decodability of the code block cannot be inferred and the user may be requested for retransmission. This scenario is schematically illustrated in Fig. 11. In this case, the information can be used by the MAC scheduler to adjust the amount of data that the users are allowed to send in order to adapt to the availability of computing capacity, as already described above.

It should be noted that a high rate of false positives or false negatives when inferring the decodability of data may lead to poor performance. However, as will be appreciated by those skilled in the art, this issue can be fixed by appropriately building the classifier and by using conservative predictions.

To summarize, embodiments of the present invention include the following important aspects:

(1) Exploiting extrinsic information in belief propagation algorithms used in data decoders such as turbo decoders or LDPC decoders used in 4G and 5G networks to infer the decodability of data upon exhausting a computing time budget.

(2) Sending acknowledgment (ACK) to a user based on the decodability inferred in the previous step while the decoder continues processing the data in parallel.

(3) Using information about the decodability of data in step (1) to adapt the rate at which uplink data is scheduled to the availability of computing capacity.

**Claims**

1. A method of operating a virtualized radio access point, vRAP (110), the method comprising:

decoding transport blocks, TBs, by using iterative codes that exchange extrinsic information in each iteration;
inferring information about the decodability of the data of the TBs by exploiting the exchanged extrinsic information, wherein inferring information about the decodability of the data of the TBs includes determining, based on an analysis of the exchanged extrinsic information, a decodability status of the data as either 'decodable', 'undecodable' or 'unknown'; and
using the inferred information about the decodability of data to adapt a rate at which uplink data is scheduled to the availability of the vRAP's (110) computing capacity, including:

if the data of the TBs are determined to be decodable, increasing the amount of data the vRAP's (110) MAC scheduler (134) is allowed to allocate to users, and/or

if the data of the TBs are determined to be undecodable or if the inferred information about the decodability do not permit to determine whether the data of the TBs are decodable or not, decreasing the amount of data the vRAP's (110) MAC scheduler (134) is allowed to allocate to users.

2. The method according to claim 1, wherein the codes used for decoding transport blocks, TBs, include turbo codes and/or LDPC, codes employing iterative belief propagation algorithms.

3. The method according to claim 1 or 2, wherein inferring information about the decodability of the data of the TBs is performed when a deadline for computing signals to send feedback to respective users expires.

4. The method according to any of claims 1 to 3, further comprising:

determining the mean magnitude of an extrinsic LLR value after the last decoding iteration; and
inferring that the respective data are decodable if the determined magnitude exceeds a first configurable threshold.

5. The method according to any of claims 1 to 4, further comprising:

determining the trend of the mean magnitude of an extrinsic LLR value over the decoding iterations; and
inferring that the respective data are decodable if the determined trend exceeds a second configurable threshold.

6. The method according to any of claims 1 to 5, further comprising:

if user data are determined to be decodable, sending an acknowledgement, ACK, to a respective user; and
continuing decoding the user data in parallel.

7. The method according to any of claims 1 to 6, further comprising:
if user data are determined to be undecodable or if the inferred information about the decodability do not permit to determine whether user data are decodable or not, stopping decoding the data and computing the signals to request a respective user to retransmit the data.

8. A virtualized radio access point, vRAP (110), in particular for execution of a method according to any one of claims 1 to 7, comprising:

a decoder configured to decode transport blocks, TBs, by using iterative codes that exchange extrinsic information in each iteration;
a digital signal processor, DSP, pipeline configured to infer information about the decodability of the data of the TBs by exploiting the exchanged extrinsic information, wherein the DSP pipeline is configured to determine, based on an analysis of the exchanged extrinsic information, a decodability status of the data as either 'decodable', 'undecodable' or 'unknown', and
a scheduler (134) configured to use the inferred information about the decodability of data to adapt a rate at which uplink data is scheduled to the availability of the vRAP's (110) computing capacity, wherein
if the data of the TBs are determined to be decodable, the amount of data the scheduler (134) is allowed to allocate to a respective user is increased, and/or
if the data of the TBs are determined to be undecodable or if the inferred information about the decodability do not permit to determine whether the data of the TBs are decodable or not, the amount of data the scheduler (134) is allowed to allocate to a respective user is decreased.

9. The virtualized radio access point according to claim 8, wherein the decoder is a turbo decoder (650) configured to operate based on two interleaved convolutional codes; or
wherein the decoder is configured to use low-density parity check, LDPC, codes.

10. The virtualized radio access point according to claim 9, wherein the turbo decoder (650) is configured to execute a belief propagation algorithm that is implemented by two convolutional decoders (660) that exchange extrinsic log-likelihood ratios, LLRs, iteratively, wherein the LLRs represent a reliability information computed for a received sequence of systematic bits and parity bits generated by the corresponding turbo encoder.

**Patentansprüche**

1. Verfahren zum Betreiben eines virtualisierten Funkzugangspunkts, vRAP (110), wobei das Verfahren umfasst:

   Decodieren von Transportblöcken (TBs) unter Verwendung iterativer Codes, die in jeder Iteration extrinsische Informationen austauschen;
   Ableiten von Informationen über die Decodierbarkeit der Daten der TBs durch Auswerten der ausgetauschten extrinsischen Informationen, wobei das Ableiten von Informationen über die Decodierbarkeit der Daten der TBs das Bestimmen eines Decodierbarkeitsstatus der Daten als entweder "decodierbar", "nicht decodierbar" oder "unbekannt" auf der Grundlage einer Analyse der ausgetauschten extrinsischen Informationen umfasst; und
   Verwenden der abgeleiteten Informationen über die Decodierbarkeit der Daten, um eine Rate, mit der Uplink-Daten eingeplant werden, an die Verfügbarkeit der Rechenkapazität des vRAP (110) anzupassen, wobei dies umfasst:

   falls die Daten der TBs als decodierbar bestimmt werden, Erhöhen der Datenmenge, die der MAC-Scheduler (134) des vRAP (110) den Nutzern zuweisen darf, und/oder
   falls die Daten der TBs als nicht decodierbar bestimmt werden oder die abgeleiteten Informationen über die Decodierbarkeit keine Bestimmung darüber zulassen, ob die Daten der TBs decodierbar sind oder nicht, Verringern der Datenmenge, die der MAC-Scheduler (134) des vRAP (110) den Nutzern zuweisen darf.

2. Verfahren nach Anspruch 1, wobei die zum Decodieren von Transportblöcken, TBs, verwendeten Codes Turbocodes und/oder LDPC-Codes umfassen, die iterative Belief-Propagation-Algorithmen verwenden.

3. Verfahren nach Anspruch 1 oder 2, wobei das Ableiten von Informationen über die Decodierbarkeit der Daten der TBs durchgeführt wird, wenn eine Frist für die Berechnung von Signalen zum Senden von Rückmeldungen an jeweilige Nutzer abläuft.

4. Verfahren nach einem der Ansprüche 1 bis 3, weiterhin umfassend:

   Bestimmen des mittleren Betrags eines extrinsischen LLR-Wertes nach der letzten Decodierungsiteration; und
   Ableiten, dass die jeweiligen Daten decodierbar sind, wenn der bestimmte Betrag einen ersten konfigurierbaren Schwellenwert überschreitet.

5. Verfahren nach einem der Ansprüche 1 bis 4, weiterhin umfassend:

   Bestimmen des Trends des mittleren Betrags eines extrinsischen LLR-Werts über die Decodierungsiterationen hinweg; und
   Ableiten, dass die jeweiligen Daten decodierbar sind, wenn der bestimmte Trend einen zweiten konfigurierbaren Schwellenwert überschreitet.

6. Verfahren nach einem der Ansprüche 1 bis 5, weiterhin umfassend:

   falls Nutzerdaten als decodierbar bestimmt werden, Senden einer Bestätigung, ACK, an einen jeweiligen Nutzer; und
   paralleles Fortsetzen der Decodierung der Nutzerdaten.

7. Verfahren nach einem der Ansprüche 1 bis 6, weiterhin umfassend:
   falls Nutzerdaten als nicht decodierbar bestimmt werden oder die abgeleiteten Informationen über die Decodierbarkeit keine Bestimmung darüber zulassen, ob Nutzerdaten decodierbar sind oder nicht, Abbrechen der Decodierung der Daten und Berechnen von Signalen zur Aufforderung an einen jeweiligen Nutzer, die Daten erneut zu übertragen.

8. Virtualisierter Funkzugangspunkt, vRAP (110), insbesondere zur Ausführung eines Verfahrens nach einem der Ansprüche 1 bis 7, umfassend:

einen Decoder, der dazu konfiguriert ist, Transportblöcke, TBs, unter Verwendung iterativer Codes zu decodieren, die in jeder Iteration extrinsische Informationen austauschen;

eine digitale Signalprozessor (DSP)-Pipeline, die dazu konfiguriert ist, Informationen über die Decodierbarkeit der Daten der TBs durch Auswertung der ausgetauschten extrinsischen Informationen abzuleiten, wobei die DSP-Pipeline dazu konfiguriert ist, auf der Grundlage einer Analyse der ausgetauschten extrinsischen Informationen einen Decodierbarkeitsstatus der Daten als entweder "decodierbar", "nicht decodierbar" oder "unbekannt" zu bestimmen; und

einen Scheduler (134), der dazu konfiguriert ist, die abgeleiteten Informationen über die Decodierbarkeit der Daten zu verwenden, um eine Rate, mit der Uplink-Daten eingeplant werden, an die Verfügbarkeit der Rechenkapazität des vRAP (110) anzupassen, wobei

falls die Daten der TBs als decodierbar bestimmt werden, die Datenmenge, die der Scheduler (134) einem jeweiligen Nutzer zuweisen darf, erhöht wird, und/oder

falls die Daten der TBs als nicht decodierbar bestimmt werden oder die abgeleiteten Informationen über die Decodierbarkeit keine Bestimmung darüber zulassen, ob die Daten der TBs decodierbar sind oder nicht, die Datenmenge, die der Scheduler (134) einem jeweiligen Nutzer zuweisen darf, verringert wird.

9. Virtualisierter Funkzugangspunkt nach Anspruch 8, wobei der Decoder ein Turbodecoder (650) ist, der zum Betrieb auf der Grundlage von zwei verschachtelten Faltungscodes konfiguriert ist; oder wobei der Decoder zur Verwendung von Low-Density-Parity-Check-(LDPC)Codes konfiguriert ist.

10. Virtualisierter Funkzugangspunkt nach Anspruch 9, wobei der Turbodecoder (650) dazu konfiguriert ist, einen Belief-Propagation-Algorithmus auszuführen, der durch zwei Faltungsdecoder (660) implementiert ist, die iterativ extrinsische Log-Likelihood-Verhältnisse, LLRs, austauschen, wobei die LLRs eine Zuverlässigkeitsinformation darstellen, die für eine empfangene Sequenz von systematischen Bits und Paritätsbits berechnet wird, die durch den entsprechenden Turboencoder erzeugt wurden.

## Revendications

1. Procédé de fonctionnement d'un point d'accès radio virtualisé, vRAP (110), le procédé comportant :

le décodage de blocs de transport, TB, en utilisant des codes itératifs qui échangent des informations extrinsèques dans chaque itération ;

la déduction d'informations sur la décodabilité des données des TB en exploitant les informations extrinsèques échangées, dans lequel la déduction d'informations sur la décodabilité des données des TB inclut la détermination, sur la base d'une analyse des informations extrinsèques échangées, d'un statut de décodabilité des données comme « décodable », « non décodable » ou « inconnu » ; et

l'utilisation des informations déduites sur la décodabilité des données pour adapter un taux auquel des données de liaison montante sont planifiées à la disponibilité de la capacité de calcul du vRAP (110), incluant :

si les données des TB sont déterminées comme décodables, l'augmentation de la quantité de données que le planificateur MAC (134) du vRAP (110) est autorisé à allouer aux utilisateurs, et/ou

si les données des TB sont déterminées comme non décodables ou si les informations déduites sur la décodabilité ne permettent pas de déterminer si les données des TB sont décodables ou non, la diminution de la quantité de données que le planificateur MAC (134) du vRAP (110) est autorisé à allouer aux utilisateurs.

2. Procédé selon la revendication 1, dans lequel les codes utilisés pour le décodage de blocs de transport, TB, incluent des codes turbo et/ou des codes LDPC utilisant des algorithmes de propagation de croyance itérative.

3. Procédé selon la revendication 1 ou 2, dans lequel la déduction d'informations sur la décodabilité des données des TB est réalisée lorsqu'un délai de calcul de signaux pour envoyer un retour d'information à des utilisateurs respectifs expire.

4. Procédé selon l'une quelconque des revendications 1 à 3, comportant en outre :

la détermination de la grandeur moyenne d'une valeur LLR extrinsèque après la dernière itération de décodage ; et

la déduction que les données respectives sont décodables si la grandeur déterminée dépasse un premier seuil configurable.

5. Procédé selon l'une quelconque des revendications 1 à 4, comportant en outre :

la détermination de la tendance de la grandeur moyenne d'une valeur LLR extrinsèque sur les itérations de décodage ; et
la déduction que les données respectives sont décodables si la tendance déterminée dépasse un second seuil configurable.

6. Procédé selon l'une quelconque des revendications 1 à 5, comportant en outre :

si des données d'utilisateur sont déterminées comme décodables, l'envoi d'un accusé de réception, ACK, à un utilisateur respectif ; et
la poursuite du décodage des données d'utilisateur en parallèle.

7. Procédé selon l'une quelconque des revendications 1 à 6, comportant en outre :
si des données d'utilisateur sont déterminées comme non décodables ou si les informations déduites sur la décodabilité ne permettent pas de déterminer si des données d'utilisateur sont décodables ou non, l'arrêt du décodage des données et le calcul des signaux pour demander à un utilisateur respectif de retransmettre les données.

8. Point d'accès radio virtualisé, vRAP (110), en particulier pour l'exécution d'un procédé selon l'une quelconque des revendications 1 à 7, comportant :

un décodeur configuré pour décoder des blocs de transport, TB, en utilisant des codes itératifs qui échangent des informations extrinsèques dans chaque itération ;
un pipeline de processeur de signal numérique, DSP, configuré pour déduire des informations sur la décodabilité des données des TB en exploitant les informations extrinsèques échangées, dans lequel le pipeline DSP est configuré pour déterminer, sur la base d'une analyse des informations extrinsèques échangées, un statut de décodabilité des données comme étant « décodable », « non décodable » ou « inconnu », et
un planificateur (134) configuré pour utiliser les informations déduites sur la décodabilité de données pour adapter un taux auquel des données de liaison montante sont planifiées à la disponibilité de la capacité de calcul du vRAP (110), dans lequel
si les données des TB sont déterminées comme étant décodables, la quantité de données que le planificateur (134) est autorisé à allouer à un utilisateur respectif est augmentée, et/ou
si les données des TB sont déterminées comme non décodables ou si les informations déduites sur la décodabilité ne permettent pas de déterminer si les données des TB sont décodables ou non, la quantité de données que le planificateur (134) est autorisé à allouer à un utilisateur respectif est diminuée.

9. Point d'accès radio virtualisé selon la revendication 8, dans lequel le décodeur est un turbo-décodeur (650) configuré pour fonctionner sur la base de deux codes convolutionnels entrelacés ; ou
dans lequel le décodeur est configuré pour utiliser des codes de contrôle de parité à faible densité, LDPC.

10. Point d'accès radio virtualisé selon la revendication 9, dans lequel le turbo-décodeur (650) est configuré pour exécuter un algorithme de propagation de croyance qui est mis en œuvre par deux décodeurs convolutionnels (660) qui échangent des rapports de vraisemblance logarithmique, LLR, extrinsèques, de manière itérative, dans lequel les LLR représentent une information de fiabilité calculée pour une séquence reçue de bits systématiques et de bits de parité générés par le turbo-décodeur correspondant.

Fig. 1

EP 4 327 460 B1

Fig. 2

Fig. 3

Fig. 4

Fig. 5

a)

b)

Fig. 6

EP 4 327 460 B1

Fig. 7

EP 4 327 460 B1

$$\rho(S_{w,\Phi_n})$$

- Decodable
- Non decodable
- Unknown

Fig. 8

Fig. 9

Fig. 10

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013223485 A1
- WO 2018095796 A1
- EP 2020083054 W

**Non-patent literature cited in the description**

- **P. SALIJA** ; **B.YAMUNA**. An efficient early iteration termination for turbo decoder. *Journal of Telecommunications and Information Technology*, 2016
- Memory efficient layered decoder design with early termination for LDPC codes. **JIANGPENG LI et al.** 2011 IEEE International Symposium of Circuits and Systems (ISCAS). IEEE, 2697-2700
- **NILS STRODTHOFF et al.** Enhanced machine learning techniques for early HARQ feedback prediction. *5G.IEEE Journal on Selected Areas in Communications*, 2019, vol. 37 (11), 2573-2587
- **INTEL**. vRAN: The Next Step in Network Transformation. *White Paper*, 01 January 2019, 1-10
- **SAMSUNG**. Virtualized Radio Access Network, Architecture, Key technologies and Benefits. *Technical Report*, 01 January 2019
- Hardware implementation of Log-MAP turbo decoder for W-CDMA Node B with CRC-aided early stopping. **CHUNLONG BAI et al.** PROC., IEEE 55TH. VEHICULAR TECHNOLOGY CONFERENCE. VTC SPRING, 06 May 2002, vol. 2, 1016-1019
- Low Complexity Stopping Criterion for LDPC Code Decoders. **KIENLE F et al.** PROC., IEEE 61ST VEHICULAR TECHNOLOGY CONFERENCE. VTC2005- SPRING ; 30 MAY-1 JUNE 2005 ; STOCKHOLM, SWEDEN. IEEE, 30 May 2005, vol. 1, 606-609
- **P SALIJA et al.** An Efficient Early Iteration Termination for Turbo Decoder. *Journal of Telecommunications and Information Technology*, 01 April 2016, 113-122
- **ERIK DAHLMAN** ; **STEFAN PARKVALL** ; **JOHAN SKOLD**. The next generation wireless access technology. Academic Press, 2018